# EUROPEAN PATENT APPLICATION

(11) **EP 2 338 612 A1**
(43) Date of publication of application: **29.06.2011**
(21) Application number: 09820584.2
(22) Date of filing: 14.10.2009
(51) Int. Cl.: B05C 5/00, B41J 2/045, B41J 2/055, G02B 5/20, H01L 51/50, H05B 33/10

(54) **PRINT HEAD, PRINTER**

(30) Priority: 16.10.2008 JP 2008267662
(71) Applicant: Ulvac, Inc., Chigasaki-shi Kanagawa 253-8543 (JP)
(72) Inventor: MIYATA Takahiro, Chigasaki-shi Kanagawa 253-8543 (JP); MURATA Masao, Chigasaki-shi Kanagawa 253-8543 (JP); SHIBA Satoshi, Chigasaki-shi Kanagawa 253-8543 (JP); YAHAGI Mitsuru, Chigasaki-shi Kanagawa 253-8543 (JP); YUYAMA Jyunpei, Chigasaki-shi Kanagawa 253-8543 (JP)
(74) Representative: Körber, Martin Hans
(86) International application number: PCT/JP2009/067755
(87) International publication number: WO 2010/044406

(57) **Abstract**

Vibration is prevented from being transmitted via a common ink chamber 8 or a fixed substrate 3. A porous member 11 is disposed between the common ink chamber 8 and a pressure generation chamber 9 so that a discharge liquid passes through the interior of the porous member 11 to move from the common ink chamber 8 to the pressure generation chamber 9. Vibration generated in one pressure generation chamber 9 is attenuated through the porous member 11 when the vibration is transmitted to another pressure generation chamber 9 via the common ink chamber 8; and thus, no cross-talk is generated. Furthermore, when piezoelectric vibrators 4 having different lengths are mounted on the same fixed substrate 3 and have the resonance frequencies different from each other, vibration is not transmitted to another pressure generation chamber 9 via the fixed substrate 3 and the piezoelectric vibrator 4; and therefore, the cross-talk is much less likely to be generated.

## Description

### Technical Field

The present invention generally relates to a print head and a printer in which a discharge liquid is discharged from discharge orifices and the discharge liquid lands on an obj ect to be discharged (such as, a substrate), and especially relates to a print head and a printer which are used to manufacture a liquid crystal display device, an EL display device, or the like.

### Background Art

In recent years, an inkjet type discharge device is used to produce a color filter of a liquid crystal display device and an organic EL display device.

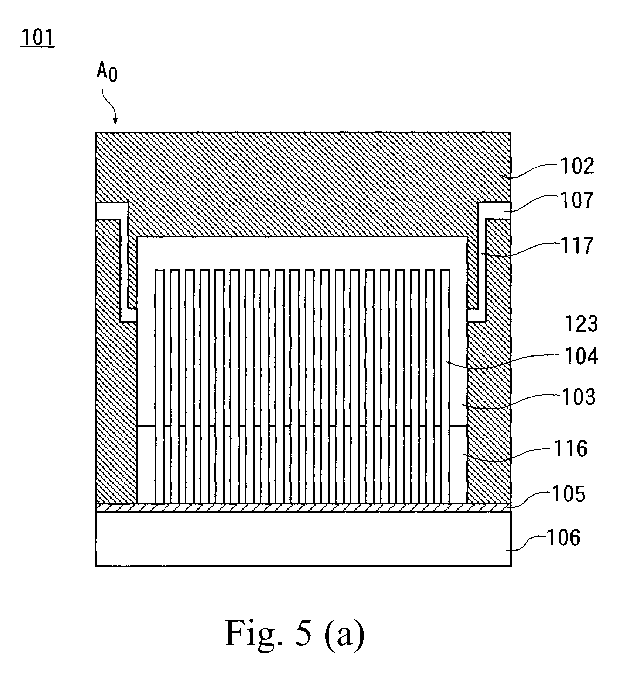

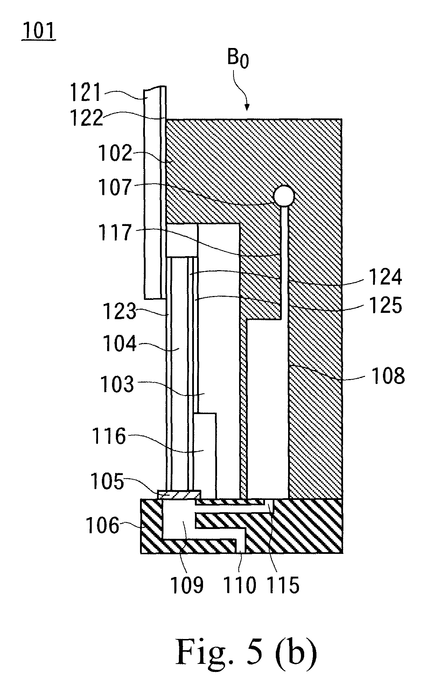

Reference numeral 101 in Figs. 5 (a) and 5 (b) denotes a part of a print head of such a discharge device, reference symbol A₀ in Fig. 5 (a) denotes a schematic front view of an internal structure of the print head; and reference symbol B₀ in Fig. 5(a) denotes a schematic side view of the print head.

A nozzle plate 106 is provided below a housing 102 of the print head 101; and a plurality of pressure generation chambers 109 is provided in the nozzle plate 106.

A discharge orifice 110 is formed at the bottom edge of each of the pressure generation chambers 109; and the top edge thereof is connected to a common ink chamber 108 provided in the housing 102.

Each of piezoelectric vibrators 104 is disposed above the pressure generation chambers 109, respectively.

A discharge liquid is supplied from an ink tank, which is disposed outside of the print head 101 and stores the discharge liquid, to the common ink chamber 108 through a supply route 117.

The discharge liquid supplied in the common ink chamber 108 is distributed to each of the pressure generation chambers 109; and the pressure chambers 109 are filled with the discharge liquid.

An elastic plate 105 located on the pressure generation chamber 109 is exposed inside each of the pressure generation chambers 109; and the piezoelectric vibrator 104 abuts the side opposite to the exposed portion of the elastic plate 105.

When a voltage is applied to the piezoelectric vibrator 104 and the piezoelectric vibrator 104 vibrates, the discharge liquid is discharged from the discharge orifice 110 of the pressure generation chamber 109 with which the piezoelectric vibrator 104 is in contact.

More specifically, a concave portion is provided in the housing 102 of the print head 101, and a fixed substrate 103 is disposed in the concave portion. Each piezoelectric vibrator 104 is fixed to the fixed substrate 103. By applying a voltage to the piezoelectric vibrator 104 and vibrating the piezoelectric vibrator 104 in the longitudinal direction, the pressure generation chamber 109 expands/ contracts via the elastic plate 105 and discharge liquid stored inside the pressure generation chamber 109 is discharged toward the substrate from the discharge orifice 110.

The piezoelectric vibrators 104 are densely arranged and adhered to the fixed substrate 103 by an adhesive layer 125. The elastic plate 105 is elastically deformed by the piezoelectric vibrator 104, and generated pressure wave is, as described above, converted into energy to discharge the discharge liquid from the discharge orifice 110. However, the pressure wave generated in each pressure generation chamber 109 intrudes into another pressure generation chamber 109 through the common ink chamber 108, and causes a cross-talk where the pressure generation chambers 109 interfere with each other.

In order to prevent such residual vibration from being transmitted, a method is disclosed in which a plurality of columnar structures for attenuating the pressure wave is arranged in a portion connecting the pressure generation chamber 109 and the common ink chamber 108.

This method attenuates mutual interference between the pressure waves by arranging the columnar structures so that the columnar structures generate resistance against the travel of the pressure wave.

However, there are problems such that this method requires a high-precision microfabrication technique of a silicon plate when manufacturing the columnar structures, as well as increasing the manufacturing cost.
[Patent Document 1] U.S. Patent No. 7,303,264

### Disclosure of the Invention

### Problems to be Solved by the Invention

The present invention is created to solve the problems relating to the above-described cross-talk, and provides an inkjet type discharge device and print head which realize stable liquid drop discharge performance by preventing the pressure waves from interfering with each other by a simple method.

### Means for Solving the Problems

In order to solve the above-described problems, the present invention is directed toward a print head which includes a plurality of pressure generation chambers, a common ink chamber for supplying a discharge liquid to each of the pressure generation chambers, a plurality of elongated piezoelectric vibrators for respectively expanding/contracting different pressure generation chambers when vibrating in a longitudinal direction, a discharge orifice which is connected to the pressure generation chamber and discharges the discharge liquid by the expansion/contraction, and a porous member which closes a connection hole connecting the common ink chamber and the pressure generation chamber and through the interior of which the discharge liquid in the common ink chamber passes when the discharge liquid moves to the pressure generation chamber.

Further, the present invention is directed toward the print head, wherein a nozzle plate, in which the pressure generation chamber and the connection hole are formed, forms one wall surface of the common ink chamber, and the porous member is in close contact with a portion around the connection hole of the nozzle plate.

Further, the present invention is directed toward the print head, wherein resonance frequencies of the respective piezoelectric vibrators are set to be different from each other.

Further, the present invention is directed toward the print head, wherein the respective piezoelectric vibrators are formed such that the lengths thereof in the longitudinal direction are different from each other.

Further, the present invention is directed toward the print head wherein one end of each of the piezoelectric vibrators is in contact with the discharge liquid inside the pressure generation chamber via an elastic member, and the other end thereof is attached to a fixed substrate by an adhesive layer.

Further, the present invention is directed toward a printer which includes a substrate stage on which a substrate as an object to be discharged is disposed, and any one of the above-described print heads, wherein the substrate stage and the print head are configured so as to be able to move relative to each other; and the discharge liquid discharged from the print head is configured so as to land on the substrate.

### Effect of the Invention

The vibration transmitted from the pressure generation chamber to the common ink chamber attenuates, and the vibration transmitted from the common ink chamber to another pressure generation chamber also attenuates, so that no cross-talk occurs.

When each piezoelectric vibrator is formed so that resonance frequencies thereof are different from each other, even if a vibration of another vibrator is applied to a vibrator in a stationary state, the vibrator in a stationary state vibrates only a little, so that no cross-talk occurs.

### Brief Description of the Drawings

Fig. 1: an example of a printer of the present invention;
Fig. 2(a) A₁: an internal front view of a print head of a first example of the present invention;
Fig. 2(b) B₁: an internal side view of the print head;
Fig. 3 A₂: an internal front view of a print head of a second example of the present invention;
Fig. 4 A₃: an internal front view of a print head of a third example of the present invention;
Fig. 5(a) A₀: an internal front view of a print head of the conventional art; and
Fig. 5(b) B₀: an internal side view of the print head of the conventional art.

### Explanation of Reference Numerals

- 1.: Print head
- 3.: Fixed substrate
- 4.: Piezoelectric vibrator
- 5.: Elastic member
- 9.: Pressure generation chamber
- 10.: Discharge orifice
- 11.: Porous member
- 15.: Connection hole
- 25.: Adhesive layer
- 53.: Substrate stage
- 58.: Substrate

### Best Modes for Carrying Out the Invention

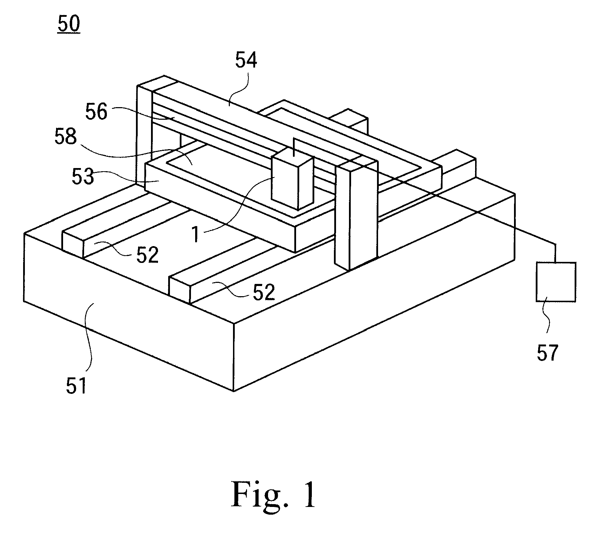

Reference numeral 50 in Fig. 1 denotes a printer of an example of the present invention.

The printer 50 includes a pedestal 51; and a substrate stage 53 is disposed on the pedestal 51 via a stage moving device 52. A device to move the substrate stage 53 is provided on the stage moving device 52, and the substrate stage 53 can reciprocate on the pedestal 51.

A bridge 54 is disposed above a moving range of the substrate stage 53. A head moving device 56 is provided to the bridge 54, and a print head 1 is movably attached to the head moving device 56. A device to move the print head 1 is provided to the head moving device 56; and the print head 1 can reciprocate above the substrate stage 53 in a direction perpendicular to the reciprocating direction of the substrate stage 53.

A discharge liquid tank 57 in which the discharge liquid is stored is provided in the printer 50.

The discharge liquid tank 57 is connected to the print head 1; and as described later, the print head 1 is configured so that the print head 1 can be supplied with the discharge liquid from the discharge liquid tank 57 and can discharge the discharge liquid.

Reference numeral 58 denotes a substrate as an object to which the discharge liquid is discharged, and the substrate is disposed on the substrate stage 53. The print head 1 can be moved to a desired position above the substrate 58 by relatively moving the print head 1 and the substrate stage 53; and in this state, when a discharge signal is output to the print head 1 from a control device not shown in the figures, the discharge liquid is discharged from the print head 1, so that it is possible to land the discharge liquid at a desired position on a surface of the substrate 58.

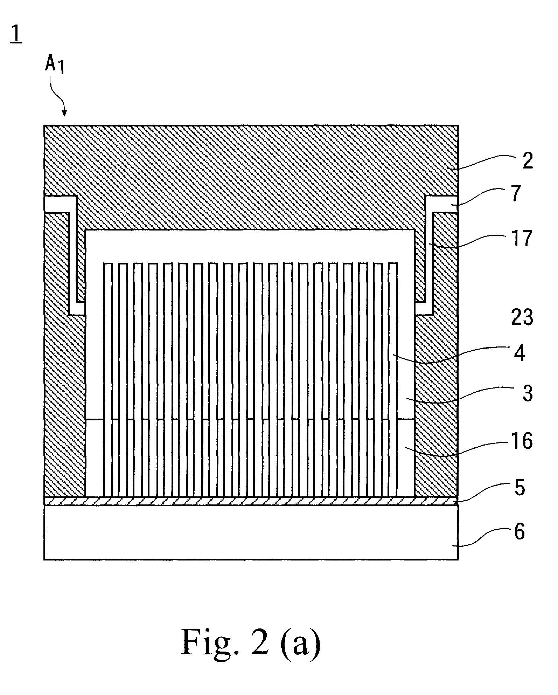

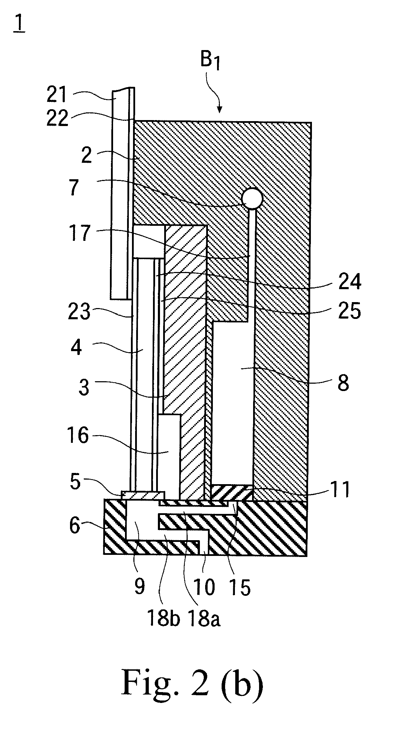

Reference symbol A₁ in Fig. 2 (a) denotes an internal front view of the print head 1 of a first example; and reference symbol B₁ in Fig. 2(b) denotes an internal side view thereof.

An internal structure of the print head 1 will hereinafter be described. The print head 1 includes a housing 2; and a nozzle plate 6 is attached to the housing 2. Here, the nozzle plate 6 is attached to the bottom edge of the housing 2 so that a surface of the nozzle plate 6 which faces downward can face toward the substrate stage 53.

A plurality of pressure generation chambers 9 is provided inside the nozzle plate 6; and a common ink chamber 8 is provided inside the housing 2.

A surface of the nozzle plate 6 which faces upward is in contact with the housing 2, and one wall surface of the common ink chamber 8 is formed by the nozzle plate 6.

Connection holes 15, the number of which is the same as that of the pressure generation chambers 9, are provided in a portion of the nozzle plate 6 which forms the one wall surface of the common ink chamber 8.

Connection paths 18a are provided inside the nozzle plate 6. The number of the connection paths 18a having one end connected to one of the different pressure generation chambers 9 and the other end connected to one of the different connection holes 15 is the same as that of the pressure generation chambers 9.

At a portion where the connection hole 15 is formed inside the common ink chamber 8, the porous member 11 is disposed in such a manner that the porous member 11 is in close contact with a portion around the connection hole 15. The portion around the connection hole 15 is the upper surface of the nozzle plate 6, as shown in the figure in this example. The portionmaybe an inner circumference surface of the connection hole 15.

A supply path 17, which connects the common ink chamber 8 to a pipe 7 connected to the discharge liquid tank 57, is provided inside the housing 2. The porous member 11 includes pores having a diameter that allows the discharge liquid to pass through. The discharge liquid, which passes through the pipe 7 and the supply path 17 and is supplied to the common ink chamber 8 from the discharge liquid tank 57, passes through a reticulated pore portion inside the porous member 11, enters the connection path 18a and is distributed to each pressure generation chamber 9.

An opening is formed in a portion of the nozzle plate 6 on the side of the housing 2, which is a wall surface of the pressure generation chamber 9; the opening is closed by an elastic member 5, such as an elastic plate or an elastic film (here, a metallic film having 5µm in the thickness) ; and when the discharge liquid is supplied into the pressure generation chamber 9 and the pressure generation chamber 9 is filled with the discharge liquid in a state where gas is removed from the inside of the pressure generation chamber 9, the elastic member 5 comes into contact with the discharge liquid.

The print head 1 includes a plurality of elongated piezoelectric vibrators 4, and one end of each of the piezoelectric vibrators 4 is in contact with the side opposite to the side of which the elastic member 5 comes into contact with the discharge liquid in the pressure generation chamber 9.

Electrodes 23 and 24 are formed on the front surface and the rear surface of the piezoelectric vibrator 4, respectively.

A circuit board 21 is attached to the housing 2; and a circuit electrode 22 formed at the circuit board 21 is in contact with and electrically connected to the electrodes 23 and 24 of the piezoelectric vibrator 4; and it is possible to apply a voltage between the electrodes 23 and 24 on the front surface and the rear surface of the piezoelectric vibrator 4.

A fixed substrate 3 is fixed to the housing 2; and each piezoelectric vibrator 4 is adhered to the fixed substrate 3 by an adhesive layer 25 at an end side of the piezoelectric vibrator 4 on the opposite side of the elastic member 5. Each piezoelectric vibrator 4 is adhered in such a way so as to be in parallel with each other.

The fixed substrate 3 is disposed upright on the nozzle plate 6, and a part of the fixed substrate 3 on the side of the nozzle plate 6 is formed in thin thickness, so that a gap 16 is formed between the part of the fixed substrate 3 and the piezoelectric vibrator 4.

When a voltage is applied between the front surface and the rear surface of the piezoelectric vibrator 4, each piezoelectric vibrator 4 vibrates in the longitudinal direction, and expands/contracts the volume of the pressure generation chamber 9 by convexing the elastic member 5 toward the outside of the pressure generation chamber 9 and concaving the elastic member 5 toward the inside of the pressure generation chamber 9. The portion where the piezoelectric vibrator 4 and the fixed substrate 3 are adhered together also vibrates in the longitudinal direction.

In the nozzle plate 6, a discharge orifice 10 is provided to each pressure generation chamber 9; and each discharge orifice 10 is connected to a different pressure generation chamber 9 respectively by a discharge path 18b provided inside the nozzle plate 6. When a voltage is applied to the piezoelectric vibrator 4 selected by the control device and the pressure generation chamber 9 expands/contracts, the discharge liquid in the pressure generation chamber 9 is discharged from the discharge orifice 10.

As described above, the porous member 11 is disposed in the middle of the path in which the discharge liquid flows between the pressure generation chamber 9 and the common ink chamber 8. Complex capillary tube paths, where fine pores communicate with each other in a net-like manner, are formed inside the porous member 11, so that the pressure wave generated in the pressure generation chamber 9 attenuates in the process of passing through pore paths in the porous member 11; and thus, the pressure wave does not reach the common ink chamber 8. Further, when the pressure wave attempts to enter another pressure generation chamber 9 from the common ink chamber 8, the pressure wave attenuates in the process of passing through the pore paths in the porous member 11; and thus, the pressure wave does not reach the other pressure generation chamber 9 from one pressure generation chamber 9 through the common ink chamber 8.

Consequently, interference of the pressure waves does not occur, and no cross-talk occurs.

The average pore diameter and the pore rate of the porous member 11 or the thickness of the porous member 11 affect the attenuation characteristics of the pressure wave. In an embodiment, the diameter of the discharge orifice 10 is 50 µm, the average pore diameter is 30 µm, the average pore rate is 69.5%, and the thickness of the porous member 11 is 1 mm, and no cross-talk occurred.

In addition to the above-described condition of the porous member 11, in an example of the porous member 11 having a thickness of 1 mm, an average pore rate is 69.5% when an average pore diameter is 20 µm, and an average pore rate is 40.9% when a an average pore diameter is 25 µm.

The material of the porous member 11 requires tolerance to the solvent of the discharge liquid; and for example, it is desired to use a metal such as stainless steel, or a material of a polyolefin organic resin.

In an example of the above-described present invention, the lengths from the end on the side in contact with the elastic member 5 to the end on the opposite side, of the respective piezoelectric vibrators 4 attached to the fixed substrate 3, are configured to be the same; and the relationships between the voltages applied to the piezoelectric vibrators 4 and the amounts of vibration are configured to be equal.

Since the lengths of the respective piezoelectric vibrators 4 are the same, the resonance frequency values are also the same, so that vibration of one piezoelectric vibrator 4 vibrates another piezoelectric vibrator 4 via the fixed substrate 3.

Therefore, if the resonance frequencies of respective piezoelectric vibrators 4 are set so as to be different from each other, in addition to the attenuation of the pressure wave passing through the common ink chamber 8 due to the porous member 11, generation of vibration of another piezoelectric vibrator 4 due to the vibration of the fixed substrate 3 can be reduced.

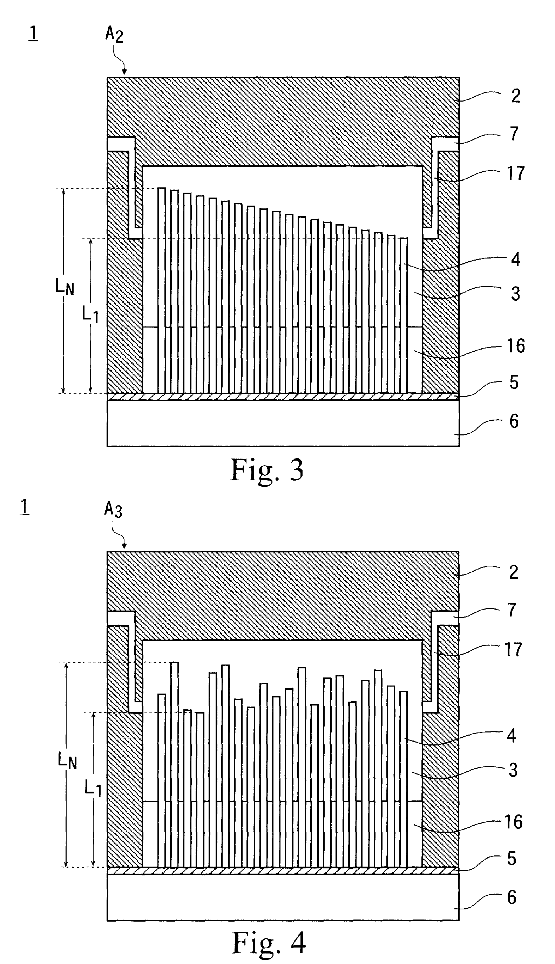

Reference symbol A₂ in Fig. 3 denotes the piezoelectric vibrators 4 which are disposed on the same fixed substrate 3 such that the lengths from the ends of the piezoelectric vibrators 4 in contact with the elastic member 5 to the opposite ends thereof are set to be different from each other; and the resonance frequencies of vibration are different from each other.

Therefore, even if residual vibration of a pressure generation chamber 9 which expanded/contracted by vibration of a piezoelectric vibrator 4 to which a voltage is applied is transmitted to the fixed substrate 3 and the vibration is transmitted to another piezoelectric vibrator 4, no cross-talk occurs because the vibration quantities of the piezoelectric vibrators 4 having different resonance frequencies are small.

When the lengths of the piezoelectric vibrators 4 are different from each other, the amplitude of the applied voltage and the amplitude of the vibration in the longitudinal direction are different for each of the piezoelectric vibrators 4. In order to discharge a constant amount of discharge liquid from each piezoelectric vibrator 4, a relationship between the amplitude of the voltage applied to each piezoelectric vibrator 4 and the amount of discharged discharge liquid is preliminarily measured, and a voltage value is obtained for each piezoelectric vibrator 4 so that the volumes of the discharge liquid landed from each discharge orifice 10 onto the substrate 58 are a constant value when the piezoelectric vibrators 4 discharge the discharge liquid for the same number of times; and thus, each piezoelectric vibrator 4 is vibrated by the obtained voltage value.

In Fig. 3 showing the above-described second example, N piezoelectric vibrators 4 having different lengths from each other are shown. When the length of the shortest piezoelectric vibrator 4 is L₁ and the length of the longest piezoelectric vibrator 4 is L_{N}, the lengths of the other piezoelectric vibrators 4 Lₖ are represented as L₁ < Lₖ < L_{N}, and the piezoelectric vibrator 4 having the shortest length L₁ is disposed at one end of the N vibrators 4 arranged in parallel with each other and the piezoelectric vibrator 4 having the longest length L_{N} is disposed at the other end. The piezoelectric vibrators 4 having different lengths are arranged in parallel with each other in an ascending order or a descending order of the lengths.

When the lengths of the piezoelectric vibrators 4 are set to be different from each other, the present invention is not limited to one in which the piezoelectric vibrators 4 are arranged in an ascending order or a descending order of the lengths as described above, but it may be that the invention includes the porous member 11, and as shown by a third example shown in a front view denoted by reference symbol A₃ in Fig. 4, the piezoelectric vibrators 4 having lengths L₁ to L_{N} different from each other so as to have different resonance frequencies are attached to the fixed substrate 3 in a random order in parallel with each other.

## Claims

1. A print head, comprising:
a plurality of pressure generation chambers;
a common ink chamber for supplying a discharge liquid to each of the pressure generation chambers;
a plurality of elongated piezoelectric vibrators for respectively expanding/contracting different pressure generation chambers when vibrating in a longitudinal direction;
a discharge orifice which is connected to the pressure generation chambers and discharges the discharge liquid by the expansion/contraction; and
a porous member which closes a connection hole connecting the common ink chamber and the pressure generation chamber and through the interior of which the discharge liquid in the common ink chamber passes when the discharge liquid moves to the pressure generation chamber.

2. The print head according to claim 1, wherein a nozzle plate, in which the pressure generation chambers and the connection hole are formed, forms one wall surface of the common ink chamber, and the porous member is in close contact with a portion around the connection hole of the nozzle plate.

3. The print head according to claim 1 or claim 2, wherein resonance frequencies of the respective piezoelectric vibrators are set to be different from each other.

4. The print head according to claim 3, wherein the respective piezoelectric vibrators are formed such that the lengths thereof in the longitudinal direction are different from each other.

5. The print head according to one of claim 1 to claim 4, wherein one end of each of the piezoelectric vibrators is in contact with the discharge liquid inside the pressure generation chamber via an elastic member, and the other end thereof is attached to a fixed substrate by an adhesive layer.

6. A printer, comprising:
a substrate stage on which a substrate as an object to be discharged is disposed; and
a print head according to one of claim 1 to claim 3,
wherein the substrate stage and the print head are configured so as to be able to move relative to each other, and the discharge liquid discharged from the print head is configured so as to land on the substrate.
